Europäisches Patentamt

European Patent Office

Office européen des brevets

(19)

(11) Publication number: **0 011 961**
**B1**

(12) **EUROPEAN PATENT SPECIFICATION**

(45) Date of publication of patent specification: **09.11.83**

(21) Application number: **79302555.2**

(22) Date of filing: **13.11.79**

(51) Int. Cl.³: **H 03 K 19/08,**
**G 11 C 17/00**

(54) Three-state output circuit.

(30) Priority: **25.11.78 JP 145831/78**

(43) Date of publication of application:
**11.06.80 Bulletin 80/12**

(45) Publication of the grant of the patent:
**09.11.83 Bulletin 83/45**

(84) Designated Contracting States:
**DE FR GB NL**

(56) References cited:
**US - A - 3 602 733**
**US - A - 3 792 292**
**US - A - 3 974 402**
**US - A - 3 980 898**
**US - A - 4 092 552**

**INTEL DATA SHEET, December 1970, pages
40—54 Mountain View, U.S.A. "Bipolar LSI
Memory 3102, 3202 Partially Decoded Random
Access 256 BIT Bipolar Memory (3102) and
Binary Decoder-Driver (3202)**
**ELECTRONICS vol. 48, no. 16, 7th August
1975, pages 101—106 New York, U.S.A. BUIE:
"Improved triple diffusion means densest ICs
yet"**

(73) Proprietor: **FUJITSU LIMITED**
**1015, Kamikodanaka Nakahara-ku**
**Kawasaki-shi Kanagawa 211 (JP)**

(72) Inventor: **Fukushima, Toshitaka**
**1604-442, Shiomidai**
**Isogo-ku Yokohama-shi, Kanagawa 235 (JP)**
Inventor: **Ueno, Kouji**
**23-10, Umegaoka**
**Midori-ku Yokohama-shi, Kanagawa 227 (JP)**

(74) Representative: **Abbott, Leonard Charles et al,**
**GILL JENNINGS & EVERY 53-64 Chancery Lane**
**London WC2A 1HN (GB)**

(56) References cited:
**ELECTRONICS vol. 43, no. 19, 14th September
1970, pages 78—84 New York, U.S.A.
SHEETS: "Three-state switching brings wired
OR to TTL"**
**IEEE JOURNAL OF SOLID-STATE CIRCUITS,
vol. SC5, no. 5, October 1970, pages 196—202
New York, U.S.A. BARRETT et al.: "Design
Considerations for a High-Speed Bipolar READ-
ONLY Memory"**

Courier Press, Leamington Spa, England.

McGraw-Hill Encyclopedia of Science and
Technology, 1977, Vol. 14, (towzyt), pages 50,
51: "Common-collector connection" and
"Selection of transistor connection"

Three-state output circuit

This invention relates to a three-state output circuit.

A three-state output circuit is very useful in fabricating memory circuits or logic circuits, for the purpose of simplifying the circuit construction. The term "three-state" represents, firstly, a normal "H" (high) level state of the output signal, secondly a normal "L" (low) level state of the output signal, and thirdly a high-impedance state "Z" of the output stage. Hence, when the three-state output circuit is caused to be active, this circuit produces, from its output stage, an "H" level output signal or an "L" level output signal in accordance with the logic significance of an input signal applied thereto. On the other hand, when the three-state output circuit is caused to be non-active, the output stage thereof adopts the high-impedance state. This high-impedance state allows, in a memory circuit system, time-sharing of a common bus line. This high-impedance state also allows, in a logic circuit, construction of a simple wired-OR logic circuit.

The three-state output circuit is divided, as a whole, into a first stage, a second stage and a third stage. The first stage functions as an input circuit which receives an input logic signal having a logic "1" or "0" significance. The third stage corresponds to the aforesaid output stage of the three-state output circuit. The second stage functions as a control circuit which causes the third stage, i.e. the output stage, to be in the high-impedance state "Z" or the normal state, in which normal state the output stage produces an "H" or an "L" level output signal in accordance with the logic significance of the input logic signal applied to the first stage, i.e. the input circuit.

As will be explained hereinafter, when the three-state output circuit is caused to be active, the control circuit operates to pass current from a power supply line via the output stage and also via the input circuit. The current to be passed from the power line to the control circuit is quite large, in the case where the control circuit is employed as a chip enable circuit in a memory device. This is because, when the memory device is constructed as a 4-bit output memory device or an 8-bit output memory device, the chip enable circuit is common to all of the four or eight output stages. In this case, the current to be passed from the power supply line and fed to the control circuit, i.e. the chip enable circuit, is called a "chip enable" current.

Since the chip enable circuit is common to all the output stages, the magnitude of the chip enable current becomes four times as high as the magnitude of the current to be passed through each input circuit and output stage, when operating as a 4-bit output memory device, or eight times as high as the magnitude of the current to be passed through each input circuit and output stage, when operating as an 8-bit output memory device.

Consequently, the chip enable circuit, i.e. the control circuit, must comprise high power transistors, and the circuit pattern therefore becomes very large. Hence, the amount of parasitic capacitance becomes very large, due to the large size of the circuit pattern. Furthermore, since the chip enable current is very large, a chip enable line must be made very wide. Furthermore, since the chip enable current is common to all of the pairs of input circuits and output stages, and all of these pairs are arranged side by side with a predetermined space between each two pairs, the chip enable line becomes very long. Hence, the amount of stray capacitance becomes very large due to the existance of the very long and wide chip enable line. The above-mentioned large amounts of both parasitic capacitance and stray capacitance result in a reduction in the operating speed of the three-state output circuit. As a result, the operating speed of the memory device is reduced.

One known form of three-state output circuit is disclosed in the publication: IEEE Journal of Solid-State Circuits, Vol. SC5, No. 5, October 1970, pages 196—202, Barrett et al, "Design Considerations for a High-Speed Bipolar Read-Only Memory". Such a circuit includes a phase-splitter transistor which drives a pair of output pull-up and pull-down transistors. An enable transistor is connected to the junction between the collector of the phase-splitter and the base of the pull-up transistor, and to ground.

However, the transistors are all of the same conductivity type, and the enable transistor is connected in the common-emitter configuration. This means that when a high level logic signal is applied to the base of the enable transistor, the input impedance of that transistor becomes very low, and an undesirably large current flows from the control circuit into the base.

In order to reduce this problem, in accordance with the present invention a three-state output circuit comprising a phase-splitter transistor of one conductivity type which is controlled by an input logic signal; a transistor pair of that conductivity type comprising a pull-up transistor and a pull-down transistor connected in series between a power supply line and a ground point, the pull-up and pull-down transistors being made conductive or non-conductive alternately to produce a "High" or a "Low" level signal from a junction therebetween under control of the phase-splitter transistor; and a control circuit which operates to make all the transistors active or non-active, in which non-active condition a high-impedance state is created at the junction is characterised in that both the base of the pull-up transistor and the collector of the phase-splitter transistor are connected to the emitter of a first transistor of the opposite conductivity type, the base of said first transistor being connected to the control circuit and the collector thereof being connected to the ground point; and in that the emitter of a second transistor of said opposite conductivity type is connected to the base of the phase-splitter transistor, the collector of said second transistor being connected to the ground point and the base thereof being connected to the control circuit in parallel with the base of said first transistor of said opposite conductivity type.

Embodiments of the invention will now be described, by way of example, with reference to the accompanying drawings, in which:

Fig. 1 is a schematic plan view of a typical IC (Integrated Circuit) memory device in which a three-state output circuit of the present invention may be employed,

Fig. 2 is a circuit diagram of a typical prior art three-state output circuit;

Fig. 3 is a circuit diagram of a first embodiment of a three-state output circuit according to the present invention;

Fig. 4 is a cross-section through a diode shown in Fig. 2;

Fig. 5A shows an equivalent circuit construction of a diode;

Fig. 5B shows an equivalent circuit construction of an improved diode utilised in the circuit shown in Fig. 2; and

Fig. 6 is a cross-section through each PNP transitor shown in Fig. 3.

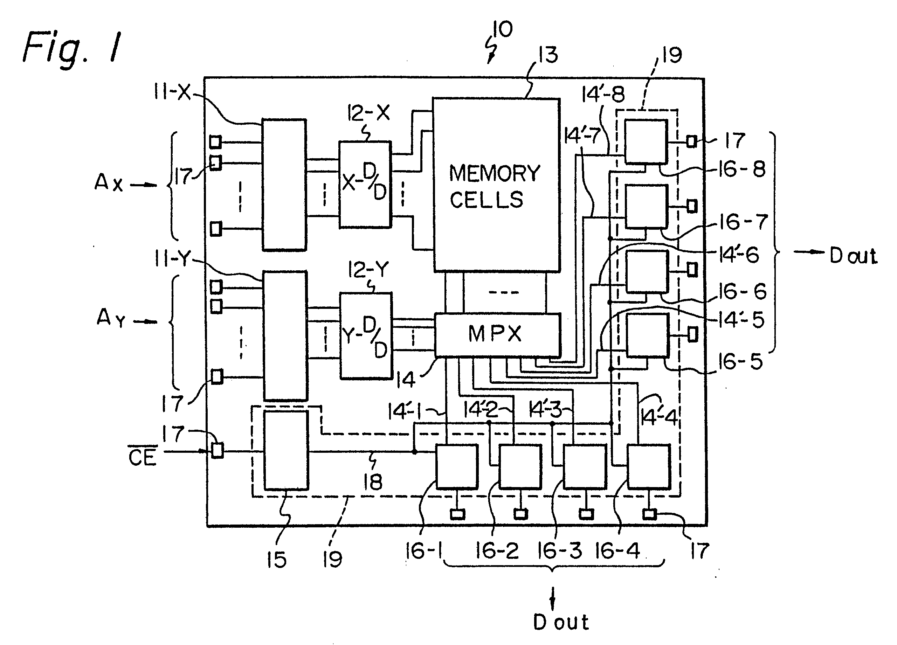

Fig. 1 schematically illustrates a plan view of a typical IC (Integrated Circuit) memory device 10 in which a three-state output circuit of the present invention may preferably be employed. The memory device 10 may be an ROM (Read Only Memory), an RAM (Random Access Memory) or a PROM (Programmable ROM). However, in Fig. 1 a PROM type memory circuit is illustrated. The memory device 10 comprises an X-address buffer (X-ADDRESS) 11-X, an X-decoder driver (X-D/D) 12-X, memory cells (MEMORY CELLS) 13, a Y-address buffer (Y-ADDRESS) 11-Y, a Y-decoder driver (Y-D/D) 12-Y, a multiplexer (MPX) 14, a chip enable circuit 15 and output buffers 16-1 to 16-8. Since, as an example, an 8-bit output memory device 10 is illustrated, there are eight of the output buffers 16-1 to 16-8. The functions of the recited components are well known to persons skilled in the art. However, these functions are, in brief, as follows.

The X-address buffer 11-X receives, via respective terminal pads 17, an X-address input signal $A_X$ and specifies one of the word lines of the memory cells 13 via the X-decoder driver 12-X. The stored data of all of the memory cells connected to the specified word line are simultaneously transferred to and latched in the multiplexer 14.

On the other hand, the Y-address buffer 11-Y receives, via respective terminal pads 17, a Y-address input signal $A_Y$ and specifies one of the bit lines of the memory cells 13 via the Y-decoder driver 12-Y and the multiplexer 14. Hence, the data corresponding to the specified bit line is selected from the data which have been latched in the multiplexer 14. The specified data, i.e. the data to be read from the memory cells 13, are 8-bit output data and are applied to the respective output buffers 16-1 to 16-8 from the multiplexer 14 via respective lines 14′-1 to 14′-8.

If the memory device 10 is caused to be active by means of the chip enable circuit 15, then the specified data are produced from the output buffers 16-1 to 16-8, via the respective terminal pads 17, as output data $D_{out}$. The data $D_{out}$ are transferred to the common bus line (not shown). If the memory device 10 is caused to be non-active by means of the chip enable circuit 15, then no data are produced from the output buffer. Whether the memory device 10 is to be active or non-active is instructed by the chip enable input signal $\overline{CE}$ to be applied to the chip enable circuit 15, and the chip enable circuit 15 controls the output buffers 16-1 to 16-8, as one body, via a chip enable line 18 so that the output buffers 16-1 to 16-8 are caused to be active or non-active, in accordance with the logic significance of the chip enable input signal $\overline{CE}$. Usually, since the memory device 10 is controlled by negative logic, the chip enable signal is represented by an inverted enable input signal CE, that is a signal $\overline{CE}$.

In Fig. 1 the present invention is specifically related to the chip enable circuit 15 and the output buffers 16-1 to 16-8, which are enclosed by a dotted line 19. In a memory system having a plurality of memory devices each of which is similar to the memory device 10 and having a common bus line which connects all of the memory devices in parallel, it is desirable to construct the circuit enclosed by the dotted line 19 of the memory device 10, and also the corresponding circuits of the remaining memory devices, as three-state output circuits. This is because the high-impedance states "Z" of the three-state circuits, which are caused to be non-active by the signal $\overline{CE}$, are, as previously mentioned, available to time-share the common bus line. That is, the output data from the three-state output circuit, which is now caused to be active, cannot be destroyed, because of the presence of the high-impedance state "Z" of the remaining three-state output circuits.

A three-state output circuit is already known, for example in "The TTL Data Book for Design Engineers" Second Edition, pages 6-36 to 6-38, issued in 1976 by the engineering staff of Texas Instruments Incorporated (Printed in U.S.A.).

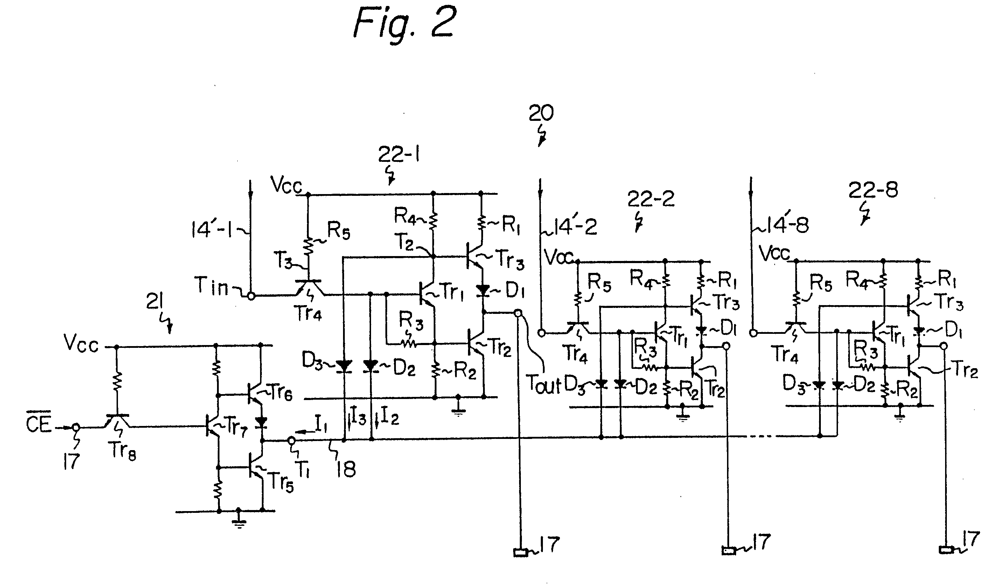

Fig. 2 illustrates a circuit diagram of a prior art three-state output circuit. In Fig. 2, the three-state output circuit 20 corresponds to the circuit enclosed by the dotted line 19 in Fig. 1. However, the three-state output circuit 20 basically comprises a control circuit 21 (corresponding the the chip enable circuit 15 shown in Fig. 1) and at least one of the circuits 22-1 to 22-8 which correspond, respectively, to the output buffers 16-1 to 16-8 shown in Fig. 1. Accordingly, the three-state output circuit comprises the control circuit 21 and one of the circuits 22-1 to 22-8, for example the circuit 22-1. Each of the remaining circuits 22-2 to 22-8 has an identical circuit construction to that of the circuit 22-1.

In operation, if the control signal, i.e. the chip enable signal $\overline{CE}$, is applied to the terminal pad 17, the circuit 22-1 (and also the circuits 22-2 to 22-8) is caused to be active. Accordingly, the circuit 22-1, i.e. the output buffer 16-1, produces a first bit of the output data $D_{out}$ from an output terminal $T_{out}$, in accordance with the logic significance of a first bit of the data, supplied from the multiplexer 14 (see Fig. 1) via the line 14'-1 and applied to an input terminal $T_{in}$. The terminal $T_{in}$ is connected to the emitter of an NPN input transistor $T_{r4}$. The transistor $T_{r4}$ is connected, at its collector, to the base of an NPN phase-splitter transistor $T_{r1}$. These transistors $T_{r4}$ and $T_{r1}$ constitute a major part of the input circuit of the three-state output circuit. The collector of the transistor $T_{r1}$ is connected to the base of an NPN pull-up transistor $T_{r3}$. The emitter of the transistor $T_{r1}$ is connected to the base of an NPN pull-down transistor $T_{r2}$. A level-shifting diode $D_1$ is connected between the emitter of the transistor $T_{r3}$ and the collector of the transistor $T_{r2}$, and the junction between the diode $D_1$ and the transistor $T_{r2}$ is connected to the terminal $T_{out}$. The transistors $T_{r3}$ and $T_{r2}$ constitute a major part of the output stage of the three-state output circuit. A diode $D_2$ is connected between the control circuit 21 and the base of the transistor $T_{r1}$. A diode $D_3$ is connected between the control circuit 21 and the base of the transistor $T_{r3}$. The two diodes $D_2$ and $D_3$ operate to create the high-impedance state "Z" of the output stage.

In a case where the control signal, i.e. the chip enable signal $\overline{CE}$ having a low level, is applied to the control circuit 21, i.e. the chip enable circuit, a transistor $T_{r5}$ of the circuit 21 is caused to be non-conductive and a transistor $T_{r6}$ of that circuit is caused to conduct. Therefore, a high level "H" signal appears at a terminal $T_1$. In such a case, when a logic "1" or "0" is applied to the terminal $T_{in}$, the transistor $T_{r4}$ is caused to be non-conductive or conductive, respectively, and accordingly, the transistor $T_{r1}$ is caused to be conductive or non-conductive, respectively. The transistor $T_{r2}$ is caused to be conductive or non-conductive, when the transistor $T_{r1}$ becomes conductive or nonconductive, respectively. On the other hand, the transistor $T_{r3}$ is caused to be non-conductive or conductive, when the transistor $T_{r1}$ becomes conductive or non-conductive, respectively. In short, the transistor $T_{r2}$ is operated in the same mode as that of the transistor $T_{r1}$, whereas the transistor $T_{r3}$ is operated in the reverse mode to the transistor $T_{r1}$. Thus, if a logic "1" is applied to the terminal $T_{in}$, the transistor $T_{r3}$ is caused to be non-conductive and the transistor $T_{r2}$ is caused to be conductive, and an output signal having an "L" level is therefore produced from the terminal $T_{out}$. Contrary to the above, if a logic "0" is applied to the terminal $T_{in}$, the transistor $T_{r3}$ is caused to be conductive and the transistor $T_{r2}$ is caused to be non-conductive, and an output signal having an "H" level is therefore produced from the terminal $T_{out}$.

On the other hand, in a case where the control signal, i.e. the chip enable signal $\overline{CE}$ having a high level, is applied to the control circuit 21, i.e. the chip enable circuit, the transistor $T_{r5}$ is caused to be conductive and the transistor $T_{r6}$ is caused to be non-conductive. Therefore, a low level "L" signal, for example 0.4V, appears at the terminal $T_1$. In such a case, the low level "L" signal at the terminal $T_1$ is applied to the bases of both of the transistors $T_{r1}$ and $T_{r2}$ via the diode $D_2$, and the low level "L" signal at the terminal $T_1$ is also applied to the base of the transistor $T_{r3}$. Consequently, the transistors $T_{r2}$ and $T_{r3}$ forming the output stage of the three-stage output circuit, are turned off simultaneously, and the high-impedance "Z" therefore appears at the terminal $T_{out}$.

When the circuit 22-1 is made active, the diodes $D_2$ and $D_3$ function to prevent reverse current from flowing from the terminal $T_1$ of the circuit 21. When the circuit 22-1 is non-active, the diodes $D_2$ and $D_3$ function, as previously explained, to make each of the transistors $T_{r1}$, $T_{r2}$ and $T_{r3}$ non-conductive, so as to create the high-impedance state "Z" at the terminal $T_{out}$. The circuit 22-1 is caused to be non-active when the control signal, i.e. the chip enable signal $\overline{CE}$ having a high level, is applied to the control circuit 21, and the transistor $T_{r5}$ is thereby caused to be conductive. Accordingly, when the circuit 22-1 is caused to be non-active, control currents $I_2$ and $I_3$ flow via the diodes $D_2$ and $D_3$, respectively, from the circuit 22-1 to the transistor $T_{r5}$ which is now conductive.

The magnitudes of the control currents $I_2$ and $I_3$ are calculated by the following procedure. The potential level at a junction $T_2$ becomes about 3.8V which is derived from

$$3.8V = 5V - 1.2V$$

The value 5V denotes the voltage of a power supply line ($V_{cc}$), and the value 1.2V is derived from

$$1.2V = 0.4V + 0.8V$$

The value 0.4V denotes the output signal level, at the terminal $T_1$ as previously mentioned, and the value 0.8V denotes the forward voltage drop across the diode $D_3$. The magnitude of the control current $I_3$ may then be calculated from

$$I_3 = \frac{3.8V}{1\ k\Omega} \simeq 4\ mA$$

The value 3.8V is, as mentioned above, the potential level at the junction $T_2$, the value 1 k$\Omega$ is the value of a resistor $R_4$. Resistance values of resistors $R_1$, $R_2$ and $R_3$ are selected to be 0.1 k$\Omega$, 1.0 k$\Omega$ and 2.5 k$\Omega$, respectively.

The potential level at a point $T_3$ becomes about 3.0V which is derived from

$$3.0V = 5V - 2.0V$$

The value 5V denotes the voltage of the power supply line ($V_{cc}$), the value 2.0V is derived from

$$2.0V = 0.4V + 0.8V + 0.8V$$

The value 0.4V denotes the output signal level, as previously mentioned, at the terminal $T_1$, the value 0.8V denotes the forward voltage drop across the diode $D_2$, and the value 0.8V denotes the base-collector voltage of the transistor $T_{r4}$. The magnitude of the control current $I_2$ may then be calculated from the equation

$$I_2 = \frac{2.6V}{6\ k\Omega} \simeq 0.5\ mA$$

The voltage 3.0V is, as mentioned above, the potential level at the point $T_3$, and the value 6 k$\Omega$ is the resistance of a resistor $R_5$. As a result, the sum of the control currents $I_2$ and $I_3$, i.e. a control current $I_1$, becomes 4.6 mA (4.0 mA+0.5 mA). As a result, the transistor $T_{r5}$ must pass the control current $I_1$ of 4.5 mA. This control current flows via a control line 18 shown in Figs. 1 and 2, as the chip enable current. However, it should be noted that a control current of 4.5 mA is also produced from each of the circuits 22-2 through 22-8, simultaneously. Hence, the magnitude of the control current $I_1$ generated by the eight circuits 22-1 to 22-8 reaches 36 mA (8×4.5 mA).

Since the transistor $T_{r5}$ of the circuit 21 must pass the very large total control current, such as 36 mA, this transistor must be a high power transistor. Transistors $T_{r7}$ and $T_{r8}$ of the circuit 21 must also be high power transistors, in order to supply a very large base current to the transistor $T_{r5}$. Hence, the control circuit 21 must be fabricated by higher power transistors and, accordingly, the circuit pattern of the circuit 21 becomes very large. As a result, the amount of parasitic capacitance becomes very large due to the presence of the large circuit pattern. Accordingly, the operating speed of the three-state output circuit is considerably reduced. Furthermore, the long line 18 must be wide to allow the flow of the large control current $I_1$. As a result, the amount of stray capacitance is very large due to the presence of the very long and wide line 18. This also results in a reduction in the operating speed of the three-state output circuit.

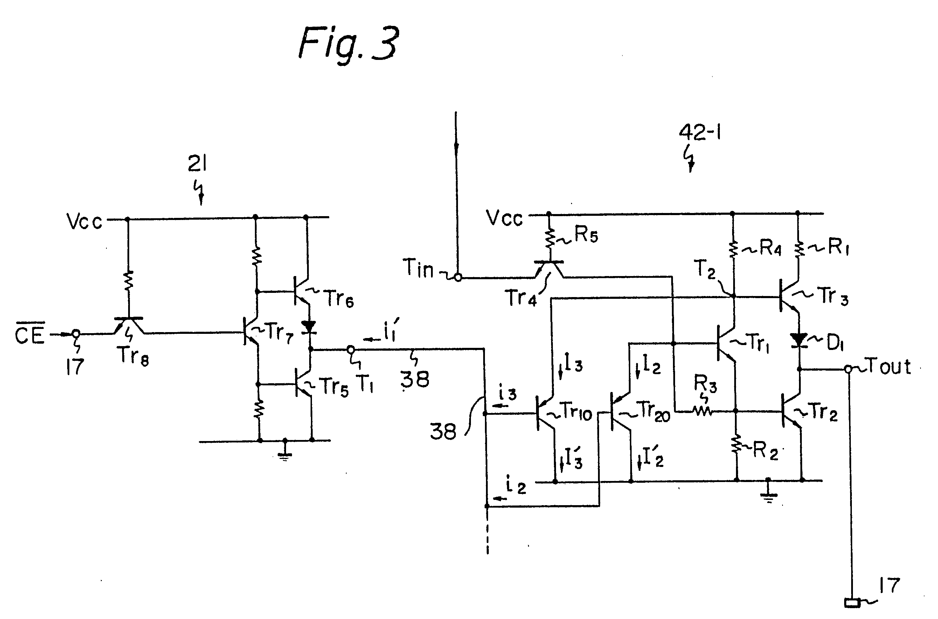

In the present invention, the above-mentioned large parasitic and stray capacitances are decreased by reducing the magnitude of the control current $I_1$ flowing through the circuit 21 and the line 18. For the purpose of reducing the magnitude of the control current $I_1$, according to the present invention, both of the diodes $D_2$ and $D_3$ are replaced by PNP transistors. Fig. 3 illustrates a first embodiment of the three-state output circuit according to the present invention. It should be understood that, since the basic construction of the three-state output circuit comprises the control circuit 21 and at least one of the circuits 22-1 to 22-8 shown in Fig. 2, only one improved circuit 42-1 (replacing the circuit 22-1 of Fig. 2) is illustrated in Fig. 3. In the Fig. 3 circuit, members which are represented by the same reference numerals or symbols as in Fig. 2, are identical in the two figures. As can be seen in Fig. 3, a PNP transistor $T_{r10}$ is newly introduced into the three-state output circuit instead of the diode $D_3$ shown in Fig. 2. The emitter of the transistor $T_{r10}$ is connected to the junction $T_2$ (as is the anode of the diode $D_3$ shown in Fig. 2). The collector of the transistor is connected to ground potential. The base of the transistor is connected to the terminal $T_1$ of the circuit 21 (as is the cathode of the diode $D_3$). In this case, a line 38 corresponds to the line 18 shown in Figs. 1 and 2.

Due to the presence of the transistor $T_{r10}$, the control current $I_3$ is separated into a control current $I_3'$ and a control current $i_3$. The magnitude of the control current $i_3$ is given by

$$i_3 = \frac{I_3}{\beta}$$

where $\beta$ is a current gain factor of the transistor $T_{r10}$ and the value of $\beta$ generally lies between 20 and 100. In a case where $\beta$ is equal to 100, the magnitude of the current $i_3$ becomes equal to

$$\frac{I_3}{100}$$

A major part of the current $I_3$ is directly passed to ground as a current $I_3'$, the magnitude of which is equal to

$$(I_3 - \frac{I_3}{100})$$

A function which is identical to the function of the diode $D_3$ for preventing the flow of reverse current from the circuit 21 is still maintained, even though the diode $D_3$ is replaced by the transistor $T_{r10}$. This is because no current flows from the base of the PNP transistor $T_{r10}$ to its emitter.

Furthermore, the diode $D_2$ is replaced by a PNP transistor $T_{r20}$. The major part of the current $I_2$ from a circuit 42-1 passes directly to ground as a current $I'_2$, the magnitude of which is equal to

$$(I_2 - \frac{I_2}{\beta})$$

where $\beta$ is the current gain factor of the transistor $T_{r20}$. If the value of $\beta$ is equal to 100, the control current $I_2$ of the prior art is reduced to a control current $i_2$, the magnitude of which is equal to one hundredth of the magnitude of the current $I_2$.

The control current $i'_1$ which has to be provided by the transistor $T_{r5}$ in this embodiment is the sum of $i_2$ and $i_3$, which is very small compared with the control current

$$I_1 = I_2 + I_3$$

of Fig. 2.

The above-mentioned function of the diode $D_2$, for preventing the flow of the reverse current from the circuit 21 is still maintained by the transistor $T_{r20}$ which replaces the diode $D_2$. The reason has already been explained with regard to the transistor $T_{r10}$.

The very small control current $i'_1$ flows through the line 38 and the transistor $T_{r5}$ of the control circuit 21. Therefore, the control circuit 21 can be fabricated of low-power transistors. Since the low-power transistors generally have very small circuit patterns, the size of the aforesaid parasitic capacitance is considerably reduced. Further, since the very small control current flows through the line 38, the width of the line 38 can be considerably smaller and, accordingly, the amount of the stray capacitance created along the line 38 becomes very small. Consequently, the operating speed of the three-state output circuit can be increased compared to the prior three-state output circuit including the diodes $D_2$ and $D_3$ shown in Fig. 2.

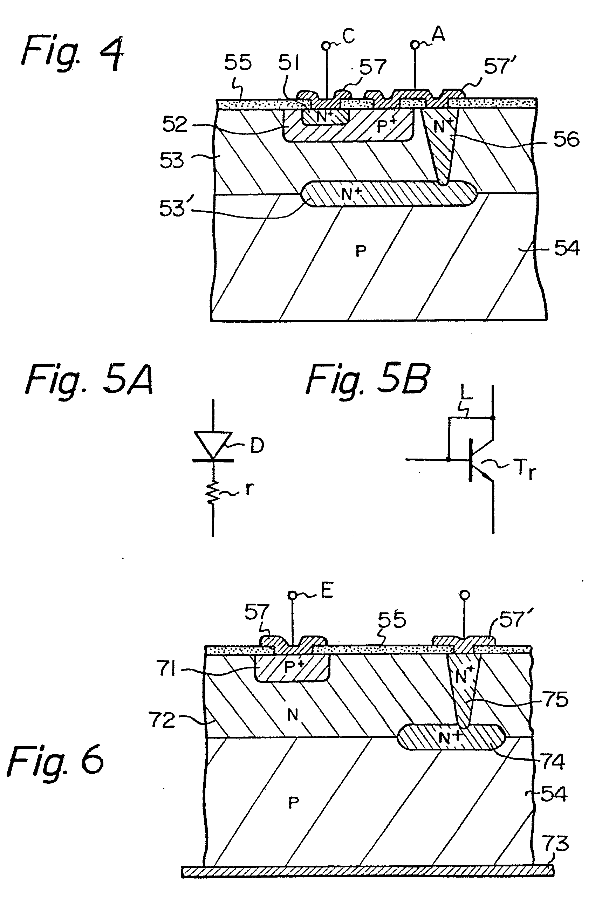

The three-state output circuit of the present invention has the following further advantages which will be clarified with reference to Figs. 4, 5A, 5B and 6. In Fig. 4, which illustrates a cross-sectional view of the diode $D_2$ (which is also the same as the diode $D_3$), a terminal C indicates the cathode of the diode and a terminal A indicates the anode thereof. The cathode terminal C is connected to an $N^+$-type region 51, i.e. an emitter area of an NPN transistor. This NPN transistor comprises a $P^+$-type region 52, i.e. the base area, and an N-type region 53 and $N^+$-type buried region 53', both regions 53 and 53' being a collector area. Both regions 53 and 53' are formed on a P-type substrate 54. An insulation layer 55 is made of silicon dioxide $(SiO_2)$.

An equivalent circuit construction of an actual diode is schematically represented by a circuit shown in Fig. 5A. As seen from Fig. 5A, a parasitic resistance r appears at a cathode of a diode D. Therefore, an undesirable voltage drop is developed across the resistance r. In order to eliminate the undesirable voltage drop, the diode $D_2$ (and also $D_3$) is constituted by a modified NPN transistor. The equivalent circuit construction of the modified NPN transistor is schematically shown in Fig. 5B. As seen from Fig. 5B, the diode $D_2$ (and also the diode $D_3$) comprises a modified NPN transistor $T_r$. The base and collector thereof are electrically shorted by a conductive lead L.

It should be understood that the modified NPN transistor $T_r$ of Fig. 5B is realised by the above-mentioned semiconductor device shown in Fig. 4. The conductive lead L of Fig. 5B is fabricated, in Fig. 4, as an N-type conductive region 56 which acts to connect the $P^+$-type region 52 (corresponding to the base) to the regions 53 and 53' (corresponding to the collector) via a conductive electrode 57' acting as the anode terminal A.

In the present invention, the diode $D_2$ is replaced by the PNP transistor $T_{r20}$ and the diode $D_3$ is replaced by the PNP transitor $T_{r10}$. The PNP transistor $T_{r20}$ (and also the PNP transistor $T_{r10}$) can be fabricated as a PNP transistor having a cross-sectional view which is illustrated in Fig. 6. In Fig. 6, members which are represented by the same reference numerals or symbols as in Fig. 4 are the same. A $P^+$-type region 71 is the emitter area of the PNP transistor, an N-type epitaxial layer 72 is the base area of the PNP transistor. The collector area of the PNP transistor is the P-type substrate 54 itself. Since the bottom of the substrate 54 is directly connected to a conductive layer (or platform) 73 of a package (not shown) for mounting the IC chip, the conductive layer or platform itself may act as a collector terminal of the PNP transistor. An emitter terminal thereof is indicated by a reference symbol E, and connects the emitter area 71 via the conductive electrode 57. The epitaxial layer 72, acting as a base area, is connected to a conductive electrode 57' via an $N^+$-type buried layer 74 and an $N^+$-type region 75. The electrode 57' is connected to the line 38 (Fig. 3). Since the $N^+$-type buried layer 74 does not lead to the portion which is located right under the $P^+$-type region 71, the function of the PNP transistor is not lost.

As seen from Fig. 6, each of the PNP transistors $T_{r10}$ and $T_{r20}$ can be fabricated as the so-called vertical-type transistor. Accordingly, each of these PNP transistors can be very small, and will accordingly occupy a very small horizontal area on the substrate, when compared to each of the diodes $D_2$, $D_3$ (refer to Fig. 4) so-called lateral-type NPN transistor. Further, although a major part of the control current in the present invention flows through the collector of each PNP transistor, this does not cause any difficult problem in the three-state output circuit. This is because the major part of the control current passes to the substrate acting as the collector of the PNP transistor. It is due, of course, to the fact that the substrate allows a very large current to flow therethrough.

As has already been explained in detail, the three-state output circuit according to the present invention can be operated at a high operating speed, and can also be fabricated as a very small device.

## Claims

1. A three-state output circuit, comprising a phase-splitter transistor $(T_{r1})$ of one conductivity type which is controlled by an input logic signal; a transistor pair of that conductivity type comprising a pull-up transistor $(T_{r3})$ and a pull-down transistor $(T_{r2})$ connected in series between a power supply line (Vcc) and a ground point, the pull-up and pull-down transistors being made conductive or non-conductive alternately to produce a "High" or a "Low" level signal from a junction $(T_{out})$ therebetween under control of the phase-splitter transistor; and a control circuit (21) which operates to make all the transistors active or non-active, in which non-active condition a high-impedance state is created at the junction, characterised in that both the base of the pull-up transistor $(T_{r3})$ and the collector of the phase-splitter transistor $(T_{r1})$ are connected to the emitter of a first transistor $(T_{r10})$ of the opposite conductivity type, the base of said first transistor $(T_{r10})$ being connected to the control circuit (21) and the collector thereof being connected to the ground point; and in that the emitter of a second transistor $(T_{r20})$ of said opposite conductivity type is connected to the base of the phase-splitter transistor $(T_{r1})$, the collector of said second transistor being connected to the ground point and the base thereof being connected to the control circuit (21) in parallel with the base of said first transistor $(T_{r10})$ of said opposite conductivity type.

2. A circuit as claimed in Claim 1, characterised in that each of the transistors $(T_{r10}, T_{r20})$ of said opposite conductivity type is a PNP transistor which is fabricated as an integrated semiconductor device formed in and on a P-type substrate (54) the collector thereof comprising the P-type substrate itself, the bottom of which substrate is electrically connected to a conductive material on which the integrated semiconductor device is mounted, the base thereof being fabricated as an N-type layer (72) which is formed on the top of the P-type substrate and the emitter being fabricated as a $P^+$-type region (71) formed inside the N-type layer, the PNP transistor being a vertical-type transistor.

3. A circuit as claimed in Claim 2, characterised in that a plurality of circuits each comprising a phase-splitter transistor $(T_{r1})$, a pull-up transistor $(T_{r3})$ and a pull-down transistor $(T_{r2})$ constitute a plurality of output buffers of an IC memory device; and in that the control circuit constitutes a single chip enable circuit for enabling the IC memory device.

4. A circuit as claimed in Claim 3, characterised in that the PNP transistors included in the respective output buffers of the IC memory device are connected in parallel, at their respective bases, to the chip enable circuit.

## Patentansprüche

1. Dreizustandsausgangsschaltung, mit einem Phasenspaltertransistor $(T_{r1})$ von einem Leitfähigkeitstyp, welcher von einem logischen Eingangssignal gesteuert wird, mit einem Transistorpaar von diesem Leitfähigkeitstyp, welches einem Großsignal- oder Pull-up-Transistor $(T_{r3})$ und einen Kleinsignal- oder Pull-down-Transistor $(T_{r2})$ umfaßt, welche zwischen der Stromversorgungsleitung (Vcc) und Masse in Reihe geschaltet sind und abwechselnd leitend und nicht-leitend gemacht werden, um unter der Steuerung des Phasenspaltertransistors an einem gemeinsamen Verbindungspunkt $(T_{out})$ ein Großsignal oder ein Kleinsignal zu erzeugen, und einer Steuerschaltung (21), welche im Betrieb alle Transistoren aktiv oder inaktiv macht, wobei im inaktiven Zustand an dem Koppelpunkt ein Zustand mit hoher Impedanz erzeugt wird, dadurch gekennziechnet, daß sowohl die Basis des Pull-up-Transistors $(T_{r3})$ als auch der Kollektor des Phasenspaltertransistors $(T_{r1})$ mit dem Emitter eines ersten Transistors $(T_{r10})$ von entgegengesetztem Leitfähigkeitstyp verbunden sind, daß die Basis des genannten ersten Transistors $(T_{r10})$ mit der Steuerschaltung (21) und dessen Kollektor mit Masse verbunden sind, und daß der Emitter eines zweiten Transistors $(T_{r20})$ von dem genannten entgegengesetzten Leitfähigkeitstyp mit der Basis des Phasenspaltertransistors $(T_{r1})$ und der Kollektor des genannten zweiten Transistors mit Masse verbunden und seine Basis, parallel zur Basis des genannten ersten Transistors $(T_{r10})$ von entgegengesetzten Leitfähigkeitstyp, mit der Steuerschaltung (21) verbunden sind.

2. Schaltung nach Anspruch 1, dadurch gekennzeichnet, daß sich jeder der Transistoren $(T_{r10}, T_{r20})$ vom genannten entgegengesetzten Leitfähigkeitstyp ein PNP-Transistor ist, der als integrierte Halbleitereinrichtung in und auf einem P-Substrat (54) ausgebildet ist und dessen Kollektor das P-Substrat selber umfaßt, dessen Unterseite elektrisch mit einem leitfähigen Material verbunden ist, auf welchem die integrierte Halbleitereinrichtung angeordnet ist, deren Basis als N-Schicht (72) auf der Oberseite des P-Substrats ausgebildet ist und deren Emitter als $P^+$-Bereich (71) innerhalb der N-Schicht ausgebildet ist, wobei der PNP-Transistor ein vertikaler Transistor ist.

3. Schaltung nach Anspruch 2, dadurch gekennzeichnet, daß eine Mehrzahl von Schaltungen, die jeweils einen Phasenspaltertransistor ($T_{r1}$), einen Pull-up-Transistor ($T_{r3}$) und einen Pull-downTransistor ($T_{r2}$) umfassen, eine Mehrzahl von Ausgangspuffern einer IC-Speichereinrichtung bilden, und daß die Steuerschaltung eine Ein-Chip-Freigabeschaltung zur Einschaltung der IC-Speichereinrichtung bildet.

4. Schaltung nach Anspruch 3, dadurch gekennzeichnet, daß die PNP-Transistoren, welche in den entsprechende Ausgangspuffern der IC-Speichereinrichtung enthalten sind, parallel zueinander mit ihren jeweiligen Basen mit der Chip-Freigabeschaltung verbunden sind.

## Revendications

1. Circuit de sortie à trois états, comprenant un transistor déphaseur ($T_{r1}$) d'un premier type de conductivité, qui est commandé par un signal logique d'entrée; une paire de transistors ayant ce type de conductivité et comprenant un transistor de tirage vers le haut ($T_{r3}$) et un transistor de tirage vers le bas ($T_{r2}$) connectés en série entre une ligne d'alimentation électrique (Vcc) et un point de terre, les transistors de tirage vers le haut et de tirage vers le bas étant rendus alternativement conducteurs ou non conducteurs de façon à produire un signal de niveau "Haut" or "Bas" à partir du point de jonction ($T_{out}$) les reliant sous commande du transistor déphaseur; et un circuit de commande (21) qui a pour fonction de rendre tous les transistors actifs ou non actifs, un état d'impédance élevée étant créé au niveau du point de jonction dans le cas non actif, caractérisé en ce que la base du transistor de tirage vers le haut ($T_{r3}$) et le collecteur du transistor déphaseur ($T_{r1}$) sont tous deux connectés à l'émetteur d'un premier transistor ($T_{r10}$) ayant le type opposé de conductivité, la base dudit premier transistor ($T_{r10}$) étant connectée au circuit de commande (21) et son collecteur étant connecté au point de terre; et en ce que l'émetteur d'un deuxième transistor ($T_{r20}$) ayant ledit type opposé de conductivité est connecté à la base du transistor déphaseur ($T_{r1}$), le collecteur dudit deuxième transistor étant connecté au point de terre et sa base étant connectée au circuit de commande (21) en parallèle avec la base dudit premier transistor ($T_{r10}$) dudit type opposé de conductivité.

2. Circuit selon la revendication 1, caractérisé en ce que chacun des transistors ($T_{r10}$), ($T_{r20}$) dudit type opposé de conductivité est un transistor PNP qui est fabriqué sous forme d'un dispositif semi-conducteur intégré formé dans et sur un substrat de type P (54) et dont le collecteur est constitué du substrat de type P lui-même, le fond du substrat étant électriquement connecté à une substance conductrice sur laquelle le dispositif semi-conducteur intégré est monté, sa base étant fabriquée sous forme d'une couche de type N (72) qui est formée sur le dessus du substrat de type P, et son émetteur étant fabriqué sous forme d'une région de type $P^+$ (71) formée à l'intérieur de la couche de type N, le transistor PNP étant un transistor de type vertical.

3. Circuit selon la revendication 2, caractérisé en ce que plusieurs circuits, comprenant chacun un transistor déphaseur ($T_{r1}$), un transistor de tirage vers le haut ($T_{r3}$) et un transistor de tirage vers le base ($T_{r2}$) constituent plusieurs tampons de sortie d'un dispositif de mémorisation à circuit intégré; et en ce que le circuit de commande constitue un unique circuit de validation de puce permettant de valider le dispositif de mémorisation à circuit intégré.

4. Circuit selon la revendication 3, caractérisé en ce que les transistors PNP inclus dans les tampons de sortie respectifs du dispositif de mémorisation à circuit intégré sont connectés en parallèle, au niveau de leurs bases respectives, au circuit de validation de puce.

Fig. 1

MEMORY CELLS

MPX

$D_{out}$

Fig. 2

Fig. 3

Fig. 4

Fig. 5A

Fig. 5B

Fig. 6